# EUROPÄISCHE PATENTANMELDUNG

(11) **EP 0 668 554 A1**
(43) Veröffentlichungstag der Anmeldung: **23.08.1995**
(21) Anmeldenummer: 95101243.4
(22) Anmeldetag: 30.01.1995
(51) Int. Cl.: G06F 1/20

(54) **Rechner mit Feuchtigkeitsüberwachungseinheit**

(30) Priorität: 18.02.1994 DE 9402704 U
(71) Anmelder: SIEMENS AKTIENGESELLSCHAFT, 80333 München (DE)
(72) Erfinder: Trauth, Armin, D-76829 Landau (DE)

(57) **Zusammenfassung**

Es wird ein Rechner, insbesondere ein Personalcomputer vorgeschlagen, welcher die Feuchtigkeit im Innern des Rechnergehäuses überwacht und entsprechend der Parametrierung eines Feuchtigkeits- überwachungsprogramms Sicherungsmaßnahmen einleitet. Als Sicherungsmaßnahmen sind vorgesehen: die Drehzahl des Rechnerlüfters zu erhöhen, einen technischen Prozeß in einen sicheren Zustand zu fahren und die Rechnerelektronik abzuschalten.

Die Erfindung wird angewandt in Industrie-PCs.

## Beschreibung

Die Erfindung betrifft einen Rechner, insbesondere einen Personalcomputer, mit einem Gehäuse.

Ein derartiger Rechner ist aus dem Siemens-Katalog IPC10, Ausgabe 1992 bekannt. Dieser wird zur Lösung prozeßnaher Aufgaben eingesetzt, z. B. zum Erfassen von Meßwerten, Betriebs- und Maschinendaten oder zum Bedienen und Beobachten von Prozeßabläufen. Entsprechend den verschiedenen Anforderungen ist der Rechner für unterschiedliche Umgebungstemperaturen ausgelegt. Dabei ist eine Überwachungseinheit auf einer Busplatine des Rechners vorgesehen, die alle wichtigen Funktionsabläufe und Umgebungsbedingungen, z. B. Stromversorgung oder Betriebstemperatur, des Rechners überwacht. Diese Überwachungseinheit zeigt Fehler an und ermöglicht ein geordnetes Abschalten im Sinne eines definierten Rücksetzens des Rechners. Eine Überwachung der Feuchtigkeit im Innern des Rechners ist dabei nicht vorgesehen.

Der vorliegenden Erfindung liegt die Aufgabe zugrunde, einen Rechner der eingangs genannten Art zu schaffen, welcher auch die Feuchtigkeit im Rechner überwacht.

Diese Aufgabe wird durch die im kennzeichnenden Teil des Anspruchs 1 angegebenen Maßnahmen gelöst.

Vorteilhaft ist, daß der Anwender geeignete Sicherungsmaßnahmen parametrieren kann. Z. B. ist es möglich, die Erhöhung der Lüfterdrehzahl vorzusehen, um die Feuchtigkeit im Gehäuseinnern zu vermindern.

In einer bevorzugten Ausführungsform der Erfindung ist als Sicherungsmaßnahme vorgesehen, einen zu steuernden technischen Prozeß in einen sicheren Zustand nach Maßgabe eines im Rechner ablaufenden Programms zu fahren.

Weiterhin ist parametrierbar, die Rechnerelektronik bei einer zu hohen Feuchtigkeit im Gehäuse abzuschalten, wodurch Kurzschlüsse und somit Zerstörungen von Bauelementen vermieden werden.

Mehrere Sicherungsmaßnahmen sind kombinierbar und werden für den Fall einer zu hohen Feuchtigkeit nacheinander eingeleitet.

Weitere Ausgestaltungen der Erfindung ergeben sich aus den weiteren Unteransprüchen.

Anhand der Zeichnung, in der ein Ausführungsbeispiel der Erfindung dargestellt ist, werden die Erfindung, deren Ausgestaltungen sowie Vorteile näher erläutert.

Es zeigen
Figur 1 ein Blockschaltbild einer an einen Prozeß angeschlossenen Rechnersystemeinheit und
Figur 2 eine Feuchtigkeitsüberwachungseinheit.

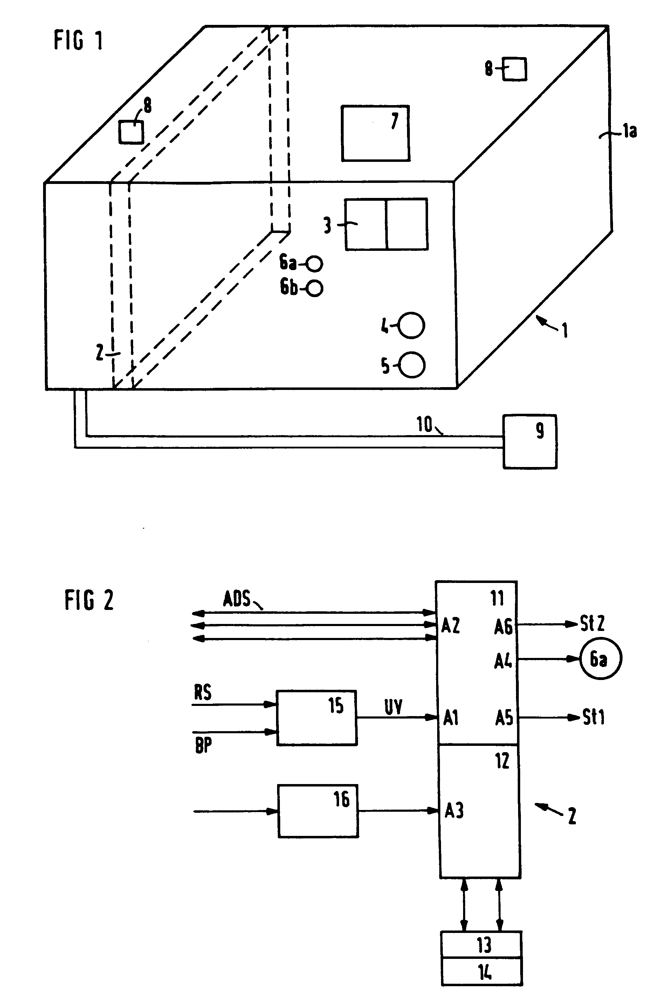

In Figur 1 ist mit 1 eine Systemeinheit eines Rechners, z. B. eines Personalcomputers, bezeichnet, deren Gehäuse 1a mit einer Feuchtigkeitsüberwachungseinheit 2 versehen ist. Über geeignete Anschlüsse ist die Feuchtigkeitsüberwachungseinheit 2 mit einer am Gehäuse angeordneten Statusanzeigeeinheit 3, einer LED-Funktionsanzeige 6a, 6b, einem Lüfter 7 sowie mit Feuchtigkeitssensoren 8 verbunden. Die Überwachungseinheit 2 ist als steckbare Baugruppe ausgebildet und zusammen mit anderen Baugruppen des Rechners, z. B. mit einer CPU-Baugruppe, einer Kommunikationsbaugruppe sowie Speicherbaugruppen, in eine mit entsprechenden Steckplätzen versehene Adreß-, Daten- und Steuerleitungen aufweisende Busplatine des Rechners gesteckt. Die Statusanzeigeeinheit 3 dient zur Anzeige von Statusmeldungen. Die LED-Funktionsanzeige 6a zeigt an, ob die zulässige Feuchtigkeit im Innern des Rechnergehäuses überschritten ist, und die LED-Funktionsanzeige 6b, ob der Lüfter 7 störungsfrei arbeitet. Mit einem KEY-LOCK-Schalter 4 ist es möglich, Rechnereingaben über eine hier nicht dargestellte Tastatur zu sperren, und mit einem RESET-Schalter 5 kann der Rechner in einen definierten Anfangszustand zurückgesetzt werden. Ein zu steuernder technischer Prozeß 9 ist über Busleitungen 10 mit der Kommunikationsbaugruppe der Systemeinheit 1 verbunden und wird nach Maßgabe eines auf der CPU-Baugruppe des Rechners ablaufenden Steuerprogramms gesteuert. Weitere Bestandteile des Rechners, wie Speicherlaufwerke oder Grafikbaugruppen, sind für die Erfindung ohne Bedeutung und brauchen nicht näher erläutert zu werden.

Figur 2 zeigt die Feuchtigkeitsüberwachungseinheit 2 mit Anschlüssen A1, A2 ... A6. Die Überwachungseinheit 2 besteht im wesentlichen aus einem Gate-Array 11 und einem Mikro-Controller 12, z. B. einem Mikro-Controller des Typs 8051 der Firma Intel, sowie Speichern in Form eines Flash-EPROMs 13 und eines RAMs 14. An dem Anschluß A1 ist eine Spannungsüberwachungseinheit 15 angeschlossen, welcher die Versorgungsspannungen RS der im Rechner eingebauten Stromversorgungseinheit und eine Batteriespannung BP zugeführt sind. Für den Fall, daß Störungen in der Stromversorgungseinheit auftreten, erzeugt die Spannungsüberwachungseinheit 15 aus der Batteriespannung BP die für den Betrieb des Gate-Arrays 11 und des Mikro-Controllers 12 erforderlichen Spannungen UV. Im störungsfreien Betrieb werden diese erforderlichen Spannungen UV aus den Versorgungsspannungen RS der Stromversorgungseinheit gewonnen. Die Anschlüsse A2 verbinden die Überwachungseinheit 2 mit den Adreß-, Daten- und Steuerleitungen ADS der Busplatine. An den Anschluß A3 sind über einen geeigneten Analog-Digital-Wandler 16 Feuchtigkeitssensoren 8 (Figur 1) angeschlossen, welche die Feuchtigkeit im Innern des Gehäuses 1 messen. Der Anschluß A4 ist mit der LED-Anzeige 6a verbunden, welche überhöhte Feuchtigkeitswerte beim Überschreiten des Feuchtigkeitsgrenzwertes im Gehäuse 1 a anzeigt. An den Anschluß A5 sind über eine Steuerleitung St1 geeignete Mittel angeschlossen, welche auf die Lüfterversorgungsspannung und somit auf die Drehzahl des Lüfters einwirken. Eine weitere Steuerleitung St2 verbindet den Anschluß A6 mit einem steuerbaren Schalter, über den die Überwachungseinheit 2 die Versorgungsspannungen der Rechnerelektronik zu- oder abschaltet. Damit in Abhängigkeit der Feuchtigkeit im Gehäuse geeignete Sicherungsmaßnahmen eingeleitet werden können, ist es zunächst erforderlich, ein entsprechendes Feuchtigkeitsüberwachungsprogramm in das Flash-EPROM 13 zu laden und zu parametrieren. Dazu wird z. B. von einem Massenspeicher des Rechners das Überwachungsprogramm in den Hauptspeicher des Rechners geladen, welches menügesteuert mit folgenden zwei Parametern zu versorgen ist:
a) mit einem Feuchtigkeitsgrenzwert, welcher während des Betriebs des Rechners mit der aktuellen Feuchtigkeit verglichen wird, und
b) mit mindestens einer einer Sicherungsmaßnahme entsprechenden Zahl.

Folgende Sicherungsmaßnahmen sind beim Überschreiten des Grenzwertes vorgesehen und parametrierbar:
- Erhöhung der Lüfterdrehzahl (1)
- Steuern des technischen Prozesses 9 in einen sicheren Zustand (2)
- Abschalten der Rechnerelektronik (3).

Nach der Parametrierung wird das Überwachungsprogramm vom Hauptspeicher in das Flash-EPROM transferiert und dort hinterlegt. Damit ist die Programmierung und Parametrierung der Überwachungseinheit 2 abgeschlossen und der Rechner kann zur Steuerung des technischen Prozesses 9 (Figur 1) eingesetzt werden. Während des Steuerbetriebs bearbeitet der Rechner den technischen Prozeß nach den Vorgaben eines vom Programmspeicher in den Arbeitsspeicher transferierten Steuerprogramms, und für den Fall, daß die Innenfeuchte im Gehäuse 1 den parametrierten Feuchtigkeitsgrenzwert überschreitet, leitet die Überwachungseinheit 2 entsprechend der Parametrierung Sicherungsmaßnahmen ein.

Für den Fall, daß die Sicherungsmaßnahme (1) parametriert ist, erhöht die Überwachungseinheit 2 über den Anschluß A5 und die Steuerleitung St1 die Lüfterversorgungsspannung und bewirkt somit eine Erhöhung der Lüfterdrehzahl.

Falls die Sicherungsmaßnahme (2) parametriert ist, zeigt die Überwachungseinheit 2 über die Adreß-, Daten- und Steuerleitungen ADS der CPU-Baugruppe eine Störung an, wodurch die CPU-Baugruppe ein Fehlerprogramm startet und den zu steuernden technischen Prozeß 9 in einen sicheren Zustand fährt. Falls die dritte Sicherungsmaßnahme parametriert ist, schaltet die Überwachungseinheit 2 über die Steuerleitung St2 die Versorgungsspannungen für die Rechnerelektronik ab. Vorzugsweise bleibt die Lüfterversorgungsspannung für eine vorgebbare, ebenfalls parametrierbare Zeitspanne aufrechterhalten, wodurch die abgeschaltete Rechnerelektronik weiter gekühlt und die Feuchtigkeit im Gehäuseinnern vermindert wird.

Das Feuchtigkeitsüberwachungsprogramm kann selbstverständlich so ausgestaltet sein, daß weitere Parameter eingestellt werden können. Z. B. ist es vorteilhaft, einen zweiten Feuchtigkeitsgrenzwert vorzusehen, um beim Unterschreiten dieses Wertes die Lüfterdrehzahl auf eine Normaldrehzahl zu schalten. Weiterhin ist es vorteilhaft, einen dritten Feuchtigkeitsgrenzwert vorzusehen. Wird dieser Grenzwert unterschritten, schaltet die Überwachungseinheit 2 die Rechnerelektronik wieder an. Man kann auch mehrere Sicherungsmaßnahmen miteinander kombinieren, die für den Fall einer zu hohen Feuchtigkeit im Gehäuseinnern nacheinander eingeleitet werden. Z. B. ist es möglich, bei einer zu hohen Feuchtigkeit im Gehäuseinnern zunächst die Lüfterdrehzahl zu erhöhen, dann den technischen Prozeß in einen sicheren Zustand zu fahren und schließlich die Rechnerelektronik abzuschalten.

Weiterhin ist es von Vorteil, das Überwachungsprogramm so auszugestalten, daß nach jedem Einschalten des Rechners für den Fall einer zu hohen Feuchtigkeit im Gehäuseinnern zunächst lediglich der Lüfter in Betrieb genommen wird, während die Rechnerelektronik so lange ausgeschaltet bleibt, bis die Feuchtigkeit den Feuchtigkeitsgrenzwert unterschreitet. Erst dann schaltet die Überwachungseinheit die Rechnerelektronik an und der Rechner läuft automatisch hoch.

## Patentansprüche

1. Rechner, insbesondere Personalcomputer, mit einem Gehäuse (1 a), gekennzeichnet durch:
- Mittel (8) zum Messen der Feuchtigkeit im Innern des Gehäuses,
- eine Feuchtigkeitsüberwachungseinheit (2), in welcher ein Feuchtigkeitsgrenzwert hinterlegt und der die Gehäuseinnenfeuchtigkeit zugeführt ist, wobei die Feuchtigkeitsüberwachungseinheit (2) die Feuchtigkeit mit dem Feuchtigkeitsgrenzwert vergleicht und beim Überschreiten des Grenzwertes entsprechend einer Parametrierung mindestens eine Sicherungsmaßnahme einleitet.

2. Rechner nach Anspruch 1, dadurch gekennzeichnet, daß als eine erste Sicherungsmaßnahme die Erhöhung der Drehzahl eines Rechnerlüfters vorgesehen ist.

3. Rechner nach Anspruch 2, dadurch gekennzeichnet, daß beim Unterschreiten eines zweiten Feuchtigkeitsgrenzwertes die Drehzahl des Lüfters auf eine Normaldrehzahl geschaltet wird.

4. Rechner nach einem der Ansprüche 1 bis 3, dadurch gekennzeichnet, daß als eine zweite Sicherungsmaßnahme ein Steuern eines durch den Rechner zu steuernden technischen Prozesses (9) in einen sicheren Zustand nach Maßgabe eines im Rechner ablaufenden Programms vorgesehen ist.

5. Rechner nach Anspruch 1 bis 4, dadurch gekennzeichnet, daß als eine dritte Sicherungsmaßnahme ein Abschalten der Rechnerelektronik vorgesehen ist.

6. Rechner nach Anspruch 5, dadurch gekennzeichnet, daß beim Unterschreiten eines dritten Feuchtigkeitsgrenzwertes die Rechnerelektronik angeschaltet wird.

7. Rechner nach einem der Ansprüche 1 bis 6, dadurch gekennzeichnet, daß beim Einschalten des Rechners die Überwachungseinheit (2) für den Fall einer zu hohen Feuchtigkeit im Gehäuseinnern nur den Lüfter einschaltet, während die Rechnerelektronik ausgeschaltet bleibt.
